# EUROPEAN PATENT APPLICATION

(11) **EP 4 496 347 A1**
(43) Date of publication of application: **22.01.2025**
(21) Application number: 24787042.1
(22) Date of filing: 19.02.2024
(51) Int. Cl.: H04R 1/10

(54) **WEARABLE DEVICE**

(30) Priority: 12.05.2023 CN 202310541798
(71) Applicant: Shenzhen Shokz Co., Ltd., Shenzhen, Guangdong 518000 (CN)
(72) Inventor: XIE, Shuailin, Shenzhen, Guangdong 518108 (CN); LIU, Chunjian, Shenzhen, Guangdong 518108 (CN); YUAN, Wenbin, Shenzhen, Guangdong 518108 (CN); XIE, Zhao, Shenzhen, Guangdong 518108 (CN); GUO, Burui, Shenzhen, Guangdong 518108 (CN)
(74) Representative: Wang, Bo
(86) International application number: PCT/CN2024/077618
(87) International publication number: WO 2024/234758

(57) **Abstract**

Disclosed is a wearable device, comprising a casing assembly, a circuit board, an interface assembly, and a wire assembly. The casing assembly is provided with an accommodation slot and an accommodation cavity, the circuit board is disposed within the accommodation cavity, and the interface assembly is inserted into the accommodation slot, and electrically connected with the circuit board through the wire assembly. By setting the interface assembly separately from the circuit board and utilizing the wire assembly to establish an electrical connection between the interface assembly and the circuit board, a space occupied by the interface assembly on the circuit board can be reduced, which is conducive to reducing the size of the circuit board, adjusting a mounting position and mounting attitude of the interface assembly, and the overall miniaturized design of the wearable device may be realized.

## Description

### TECHNICAL FIELD

The present disclosure relates to the technical field of electronic devices, and in particular, to a wearable device.

### BACKGROUND

Wearable devices such as earphones and smart glasses have become indispensable tools in people's daily lives and work. A device interface, as a necessary component of wearable devices, primarily serves the function of data transmission with external devices and supplying power to the wearable devices through an electrical connection with an external power source. A structure and assembly manner of the device interface have a critical impact on the wearable devices.

In related technology, a device interface is typically soldered directly to a mainboard of a wearable device. Assembling the mainboard with the soldered device interface into a casing of the wearable device necessitates a larger opening, which not only increases space requirements during assembly but also impedes the miniaturization of the wearable device.

### SUMMARY

The main technical problem addressed by the present disclosure is to provide a wearable device intended to make the wearable device more compact and miniaturized.

An embodiment provides a wearable device, comprising:
a casing assembly, wherein the casing assembly includes a first casing, the first casing is provided with an accommodation slot and an accommodation cavity, and the accommodation slot is in communication with the accommodation cavity;
an interface assembly, wherein the interface assembly is inserted into the accommodation slot;
a circuit board, wherein the circuit board is disposed within the accommodation cavity; and
a wire assembly, wherein the wire assembly is electrically connected with the circuit board and the interface assembly.

In one embodiment, the interface assembly further includes:
a main body portion, the main body portion being inserted into the accommodation slot; and
a flange portion, the flange portion being provided on a side of the main body portion away from the accommodation cavity;
the casing assembly is further provided with a support table surface, and the flange portion is supported by the support table surface.

In one embodiment, the interface assembly further includes a tongue portion, the main body portion is provided with a guiding cavity; a portion of the tongue portion is inserted into the guiding cavity, and the other portion of the tongue portion protrudes out of the guiding cavity from the side of the main body portion away from the accommodation cavity.

In one embodiment, an end surface of the tongue portion backing away from the main body portion along an insertion direction of the interface assembly is a first end surface, an end surface of the flange portion backing away from the main body portion along the insertion direction is a second end surface, and a height difference between the first end surface and the second end surface is in a range of 0.6 mm to 1.1 mm.

In one embodiment, the wearable device further includes a sealing member, the sealing member being arranged on the side of the main body portion away from the accommodation cavity; the sealing member being cooperatively connected with the tongue portion for selectively blocking the interface assembly.

In one embodiment, the interface assembly further includes an external circuit board, the external circuit board being disposed on a side of the main body portion proximate to the accommodation cavity, and the wire assembly is electrically connected with the external circuit board and the circuit board.

In one embodiment, a plane on which the external circuit board is located and a plane on which the circuit board is located cross with each other.
in one embodiment, the flange portion is disposed around an edge of the side of the main body portion away from the accommodation cavity;
or, a count of the flange portion is set to be a plurality, a plurality of the flange portion being spaced apart around the edge of the side of the main body portion away from the accommodation cavity.

In one embodiment, a sealant is provided between the flange portion and the support table surface.

In one embodiment, the support table surface is provided with an adhesive-accommodation slot, the flange portion covers the adhesive-accommodation slot, and at least a portion of the sealant is accommodated within the adhesive-accommodation slot;
and/or the flange portion is provided with the adhesive-accommodation slot, the support table surface covers the adhesive-accommodation slot, and at least a portion of the sealant is accommodated within the adhesive-accommodation slot.

In one embodiment, the main body portion includes an inner casing and an outer casing, and the inner casing includes a first end and a second end opposite each other along an insertion direction of the interface assembly;
the first end of the inner casing is inserted into the outer casing, and an adhesive-accommodation space for accommodating a waterproof adhesive is formed between the outer casing and the first end of the inner casing; and
the second end of the inner casing protrudes out of the outer casing to form the flange portion.

In one embodiment, the main body portion includes an inner casing and an outer casing, and the inner casing includes a first end and a second end opposite each other along an insertion direction of the interface assembly;
the first end of the inner casing is inserted into the outer casing, and an adhesive-accommodation space for accommodating a waterproof adhesive is formed between the outer casing and the first end of the inner casing, and the flange portion protrudes out of the second end of the inner casing.

In one embodiment, the main body portion further includes a reinforcement structure; the reinforcement structure is disposed at the first end of the inner casing and is located within the adhesive-accommodation space.

In one embodiment, a wall thickness of the outer casing and/or the inner casing is in a range of 0.1mm to 0.3mm.

In one embodiment, the casing assembly includes a first sidewall and a second sidewall connected at an angle, and a length of the first sidewall is greater than a length of the second sidewall, and the accommodation slot is provided in the second sidewall.

In one embodiment, the wearable device is an earphone or a pair of glasses.

The wearable device according to the above-described embodiment comprises a casing assembly, a circuit board, an interface assembly, and a wire assembly. The casing assembly is provided with an accommodation slot and an accommodation cavity, the circuit board is disposed in the accommodation cavity, and the interface assembly is inserted into the accommodation slot, and is electrically connected to the circuit board through the wire assembly. On the one hand, by setting the interface assembly separately from the circuit board and utilizing the wire assembly to establish an electrical connection between the interface assembly and the circuit board, a space occupied by the interface assembly on the circuit board can be reduced, which is conducive to reducing the size of the circuit board, adjusting a mounting position and mounting attitude of the interface assembly, and the overall miniaturized design of the wearable device may be realized. On the other hand, separating the interface assembly from the circuit board allows for the interface assembly to be mounted externally to the casing assembly, which helps reduce the size of the opening of the cavity in the wearable device and further conserves assembly space.

### BRIEF DESCRIPTION OF THE DRAWINGS

FIG. 1 is a schematic diagram illustrating an exemplary internal structure of a wearable device according to one embodiment of the present disclosure.
FIG. 2 is a schematic diagram illustrating an exemplary internal structure of a casing assembly of a wearable device according to an embodiment of the present disclosure.
FIG. 3 is a schematic diagram illustrating an assembly relationship between an interface assembly and a casing assembly of a wearable device according to an embodiment of the present disclosure.
FIG. 4 is a schematic diagram (I) illustrating an exemplary three-dimensional structure of an interface assembly according to one embodiment of the present disclosure.
FIG. 5 is a schematic diagram (II) illustrating an exemplary three-dimensional structure of an interface assembly according to one embodiment of the present disclosure.
FIG. 6 is a schematic diagram illustrating an exemplary planar structure of an interface assembly according to one embodiment of the present disclosure.
FIG. 7 is a schematic diagram (I) illustrating an exemplary structure of a flange portion of an interface assembly according to one embodiment of the present disclosure.
FIG. 8 is a schematic diagram (II) illustrating an exemplary structure of a flange portion of an interface assembly according to one embodiment of the present disclosure.
FIG. 9 is a schematic diagram (III) illustrating an exemplary structure of a flange portion of an interface assembly according to one embodiment of the present disclosure.
FIG. 10 is a schematic diagram illustrating an exemplary cross-sectional structure of an interface assembly according to one embodiment of the present disclosure.
FIG. 11 is a schematic diagram illustrating a fit relationship between structures of an interface assembly and a support table surface according to one embodiment of the present disclosure.
FIG. 12 is a schematic diagram illustrating an exemplary structure of a reinforcement structure of an interface assembly according to one embodiment of the present disclosure.
FIG. 13 is a schematic diagram illustrating a fit relationship between structures of an interface assembly and a sealing member according to one embodiment of the present disclosure.

### Numbers in the figures denote:

100, casing assembly; 110, first casing; 111, accommodation cavity; 112, accommodation slot; 120, first sidewall; 130, second sidewall; 140, support table surface; 150, second casing;
200, interface assembly; 210, main body portion; 210a, guiding cavity; 210b, adhesive-accommodation space; 211, inner casing; 212, outer casing; 213, reinforcement structure; 220, flange portion; 230, tongue portion; 240, external circuit board;
300, circuit board; 400, wire assembly; 500, sealant; and 600, sealing member.

### DETAILED DESCRIPTION

The present disclosure is described in further detail below by way of specific embodiments in conjunction with the accompanying drawings. Similar components in the different embodiments adopt associated similar component labeling. In the following embodiments, many of the details are described in order to enable the present disclosure to be better understood. However, a person skilled in the art will have no trouble recognizing that some of these features can be omitted in various embodiments or can be replaced by other components, materials, and methods. In some cases, some of the operations related to the present disclosure are not shown or described in the present disclosure, this is to prevent the core of the present disclosure from being overwhelmed by an excessive amount of description, and to a person skilled in the art, a detailed description of these related operations is not necessary, and they can fully understand the related operations according to the description in the present disclosure and the general technical knowledge in the field.

Additionally, the features, operations, or characteristics described in the present disclosure may be combined in any appropriate manner to form various embodiments. Also, the various steps or actions in the description of the method may be switched or adjusted in order in a manner that would be apparent to a person skilled in the art. The various sequences in the present disclosure and the accompanying drawings are therefore only intended to clearly describe a particular embodiment, and do not purport to be a required sequence unless otherwise indicated that one of the sequences must be followed.

The serial numbers themselves, such as "first", "second", etc., are used herein only to distinguish the objects described, and have no sequential or technical meaning. The terms "connection" and "coupling" in the present disclosure include direct and indirect connections (couplings) unless otherwise specified.

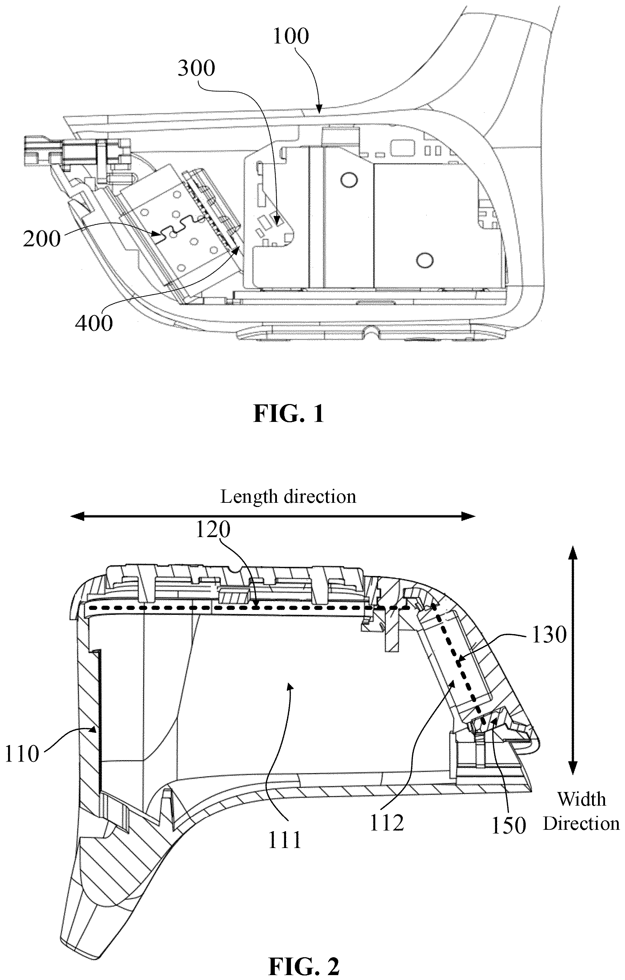

Referring to FIGs. 1 to 3, an embodiment of the present disclosure provides a wearable device, such as an earphone, a pair of glasses, a watch, a bracelet, or the like. The wearable device includes a casing assembly 100, an interface assembly 200, a circuit board 300, a wire assembly 400, and other functional components present as needed (e.g., a microphone assembly, a speaker assembly, a button assembly, a voice coil assembly, a battery assembly, etc. realizing functions related to open-ear Bluetooth headphones). A detailed description may be referred to descriptions below.

The case assembly 100 is mainly used as a mounting carrier for the interface assembly 200, the circuit board 300, and other functional components, and it is to be understood that the case assembly 100 is a collection of related components constituting an overall contour form of the wearable device. With the help of the casing assembly 100, the wearable device may be moved, carried, worn, operated, and used.

The circuit board 300 is disposed within the casing assembly 100, and the circuit board 300 may be understood as a main control board or a main board of the wearable device, which serves as a regulating and managing board for all or some of the functional components in the wearable device. For example, when the wearable device is an earphone, the circuit board 300 is used in the earphone for converting and processing an electrical signal to support the realization of various functions of the earphone (e.g., to support the earphone to realize switching on and off, switching playback contents, increasing and decreasing a volume, etc.).

The interface assembly 200 is disposed in the casing assembly 100, for example, the interface assembly 200 is disposed within the casing assembly 100 in such a manner that an interface end of the interface assembly 200 is exposed outside the casing assembly 100. The interface assembly 200 may be used for connecting to an external power source for charging the wearable device. The interface assembly 200 may also be used for connecting to an external device (e.g., a cell phone, a computer, etc.) for data transmission between the external device and the wearable device. For example, the interface assembly 200 may be a Type-C interface, a USB interface, a magnetic interface, a Lighting interface, etc., which is selected according to actual needs and is not limited herein.

In one embodiment, referring to FIG. 1 and FIG. 2, the casing assembly 100 includes a first casing 110, the first casing 110 being provided with an accommodation cavity 111 and an accommodation slot 112 that are in communication with each other. The circuit board 300 is disposed within the accommodation cavity 111, the interface assembly 200 is inserted in the accommodation slot 112, and the wire assembly 400 is electrically connected between the circuit board 300 and the interface assembly 200.

For example, the wire assembly 400 is a wire, a row of wires, a flexible printed circuit (FPC), etc., which is selected according to the actual needs and is not limited herein.

It should be noted that a bold solid line in FIG.1 to represent the wire assembly 400 is only to reflect the existence of an electrical connection relationship between the circuit board 300, the interface assembly 200, and the wire assembly 400, and does not indicate a specific structure and layout of the wire assembly 400, nor does it indicate a structural configuration of the wire assembly 400 in connection with the circuit board 300 and the interface assembly 200.

First, compared to the related technology in which the interface assembly 200 is directly soldered to the circuit board 300, by separately setting the interface assembly 200 and the circuit board 300 in the casing assembly 100, and utilizing the wire assembly 400 to electrically connect the circuit board 300 and the interface assembly 200, this not only can effectively improve a freedom degree of an installation position and installation posture of the interface assembly 200 and the circuit board 300, but also can reduce a requirement of the interface assembly 200 and the circuit board 300 for a specific size and shape for an assembly space, thereby flexibly adjusting positions and forms of the circuit board 300, the accommodation cavity 111, the interface assembly 200, and the accommodation slot 112, etc. based on an overall structural architecture of the wearable device, and creating a favorable condition for reducing a difficulty of assembling the wearable device.

Second, with an electrical connection relationship established between the circuit board 300 and the interface assembly 200 through the wire assembly 400, the circuit board 300 and the interface assembly 200 may be disposed, in the form of a certain spacing between each other, in the accommodation cavity 111 and the accommodation slot 112, respectively. Such arrangement can effectively reduce a space occupied by the interface assembly 200 on the accommodation cavity 111 or an assembly space of the circuit board 300, thereby reducing the possibility of interference of the interface assembly 200 on the circuit board 300, subsequently improving the effectiveness and stability of the operation of the interface assembly 200 and the circuit board 300, and improving the reliability and service life of the wearable device.

Third, the interface assembly 200 and the circuit board 300 are disposed in different assembly spaces, respectively, (i.e., the accommodation slot 112 and the accommodation cavity 111), and cavity openings corresponding to the interface assembly 200 and the circuit board 300 may be disposed in the casing assembly 100, which is conducive to reducing an opening size of the casing assembly 100 and saving the assembly space, thus creating a condition for enhancing the compactness of the wearable device and realizing the miniaturized design of the wearable device. The smaller opening size also effectively ensures the structural strength of a cavity and even the casing assembly 100, and facilitates the respective installation of the interface assembly 200 and the circuit board 300 (e.g., using an assembly manner where the interface assembly 200 is inserted into the accommodation slot 112 from the outside to the inside), thereby effectively reducing the assembly difficulty of the interface assembly 200, the circuit board 300, and even the wearable device.

In one embodiment, referring to FIG. 2 in connection with FIG. 1, the casing assembly 100 (specifically, the first casing 110) includes a first sidewall 120 and a second sidewall 130 connected at an angle. A length of the first sidewall 120 is greater than a length of the second sidewall 130, which may be interpreted to mean that a length of the first sidewall 120 is a length direction of the wearable device or the first casing 110, and a length direction of the second sidewall 130 may be in a same direction as a width direction of the wearable device or the first casing 110 (i.e., the first sidewall 120 and the second sidewall 130 are connected at an approximate right angle). A length direction of the second sidewall 130 may also be in a direction with a certain deflection angle relative to the width direction of the wearable device (or the first casing 110) (i.e., the first sidewall 120 and the second sidewall 130 are connected at an approximate acute angle or an approximate obtuse angle).

Taking an open-ear Bluetooth headphone as the wearable device as an example, the first sidewall 120 and the second sidewall 130 may be two sidewalls in the casing assembly 100 that are away from an ear-hanging portion of the earphone and abut against each other. The accommodation slot 112, on the other hand, is disposed in the second sidewall 130, i.e., interface assembly 200 is disposed in a width direction of the casing assembly 100 or the wearable device.

Similarly, taking a non-open-ear Bluetooth headphone as the wearable device as an example, the interface assembly 200 and other functional components (e.g., a button component) are usually disposed in a length direction of the earphone in the art, which increases the requirement for a length of the earphone (e.g., increasing a length of a relevant cavity structure within the casing assembly 100 and a length of the first sidewall 120) and is not conducive to the miniaturized design of the earphone.

In the present embodiment, by adjusting the interface assembly 200 to be disposed in the width direction of the wearable device, the requirement for the dimension of the casing assembly 100 or a cavity structure within the casing assembly 100 in a length direction of the wearable device may be effectively reduced, so that a smaller cavity structure (e.g., the accommodation slot 112) may be disposed within the casing assembly 100 to realize the assembly of functional components such as the interface assembly 200, the circuit board 300, etc., thereby facilitating the miniaturized and compact design of the wearable device.

In some embodiments, referring to FIG. 2, an angle between the first sidewall 120 and the second sidewall 130 is obtuse, which reduces the size of the wearable device in the width direction, so that the accommodation slot 112 (together with the interface assembly 200) exhibits a structural form that is inclinedly disposed with respect to the first sidewall 120, which is conducive to enhancing the structural compactness of the wearable device.

Of course, according to an overall contour form of the wearable device and the needs of the structural setup, the angle between the first sidewall 120 and the second sidewall 130 may also be set at a right angle, an acute angle, or the like, and is not limited herein.

It should be noted that a bold dotted line in FIG. 2 to indicate the first sidewall 120 and the second sidewall 130 is merely to show an approximate position and direction of the first sidewall 120 and the second sidewall 130 in the casing assembly 100, and does not represent the structural forms and sizes, etc., of the first sidewall 120 and the second sidewall 130. Meanwhile, a bold solid line with double arrows utilized in FIG. 2 illustrates the length direction and width direction of the whole wearable device.

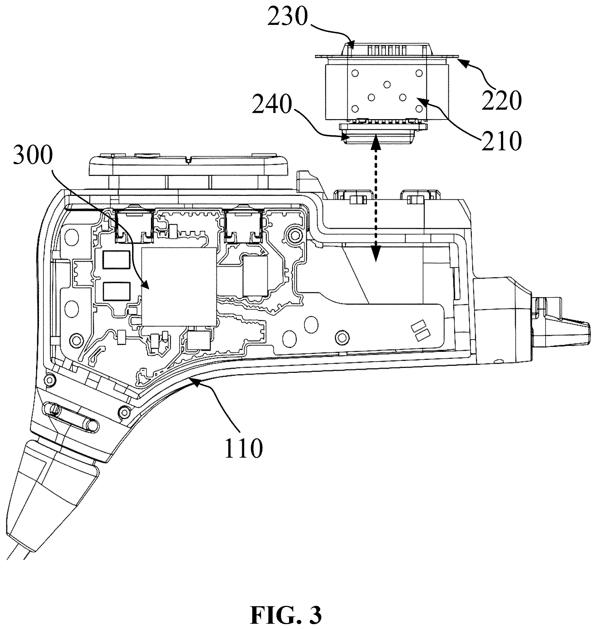

In other embodiments, referring to FIG. 3, based on an implementation principle that the interface assembly 200 is disposed separately from the circuit board 300, the accommodation slot 112 (together with the interface assembly 200) is disposed in the first sidewall 120 to meet different design requirements, which will not be repeated herein.

The following describes the interface assembly 200 and structures associated with the interface assembly 200, and other portions of the wearable device may be referred to in the prior art.

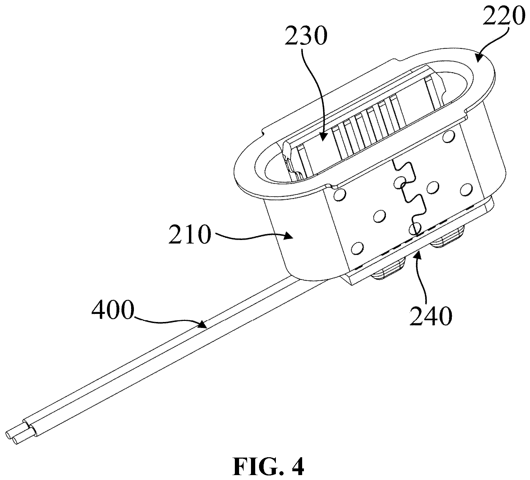

In one embodiment, referring to FIG. 1 to FIG. 11, the interface assembly 200 includes a main body portion 210 and a flange portion 220. The main body portion 210 is inserted into the accommodation slot 112 and mainly serves as a carrier for inserting and connecting the interface assembly 200 to an external plug (e.g., a power supply plug of an external power source, a data plug of an external device, etc.). The flange portion 220 is disposed on a side of the main body portion 210 away from the accommodation cavity 111. Accordingly, the casing assembly 100 (specifically, the first casing 110) is further provided with a support table surface 140, the support table surface is located on an outer side of the accommodation slot 112 away from the accommodation cavity 111, and the flange portion 220 contacts with the support table surface 140 and is supported on the support table surface 140.

On the one hand, by utilizing a fit relationship between the flange portion 220 and the support table surface 140, the interface assembly 200 may be positioned and limited in the accommodation slot 112 by simply providing an opening suitable for the insertion of the main body portion 210, which is not only conducive to reducing an opening size of the accommodation slot 112 but also conducive to saving an assembly space of the interface assembly 200.

On the other hand, please refer to FIG. 3, based on a structural form of the support table surface 140 abut against and support the flange portion 220, it is possible to quickly assemble the interface assembly 200 to the casing assembly 100 by means of an outside-to-inside assembly manner (i.e., from the outside of the casing assembly 100 towards its inside), and thus it is possible to efficiently reduce the difficulty of assembling the interface assembly 200.

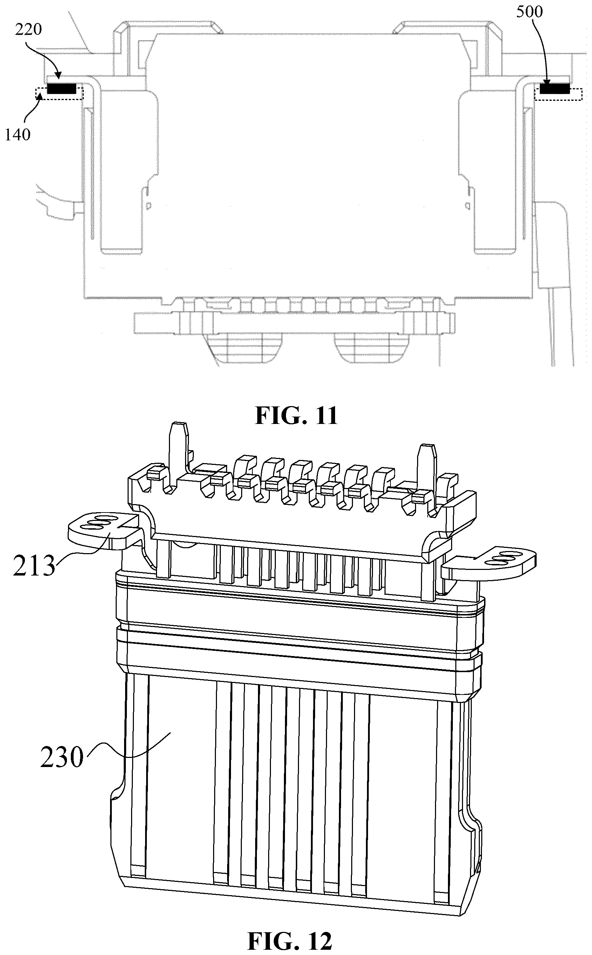

It should be noted that the support table surface 140 illustrated in FIG. 11 utilizes a dashed line wireframe only to indicate a relative position relationship between the support table surface 140 and the flange portion 220, and do not indicate a structural form and size of the support table surface 140.

Further, referring to FIG. 11, a sealant 500 is disposed between the flange portion 220 and the support table surface 140. The sealant 500 can not only secure the flange portion 220 to the support table surface 140, thereby securely assembling the interface assembly 200 in the accommodation slot 112. At the same time, the sealant 500 may also fill a structural gap between the interface assembly 200 and the casing assembly 100 on the support table surface 140 to enhance the sealing property.

In some embodiments, the support table surface 140 is provided with an adhesive-accommodation slot (not shown in the figures), the flange portion 220 covers the adhesive-accommodation slot, and at least a portion of the sealant 500 is accommodated within the adhesive-accommodation slot. Using the adhesive-accommodation slot to accommodate the sealant 500 not only further enhances the stability and sealing of the connection between the interface assembly 200 and the casing assembly 100, but also, in an insertion direction of the interface assembly 200, a height difference between the interface assembly 200 and the casing assembly 100 may be reduced, thereby making a structure of the wearable device more compact and conducive to the miniaturized design of the wearable device.

The adhesive-accommodation slot may also be disposed on the flange portion 220 or on both the flange portion 220 and the support table surface 140, which will not be repeated herein.

It should be noted that the "insertion direction of the interface assembly 200 (hereinafter referred to as the "insertion direction") is defined herein mainly to illustrate a structural fit relationship between relevant components, and the insertion direction may be understood as a direction in which the interface assembly 200 is inserted and connected with the external plug, or a direction in which the interface assembly 200 is inserted into and removed from the accommodation slot 112 during disassembly and assembly (for example, a bold dotted line with double arrows in FIG. 3 indicates the insertion direction).

In other embodiments, referring to FIG. 2 and FIG. 11, the casing assembly 100 further includes a second casing 150 connected with the first casing 110. The second casing 150 is disposed to press and block the flange portion 220 from a side of the flange portion 220 that backs away from the support table surface 140, and the sealant 500 (or together with the adhesive-accommodation slot) is disposed between the second casing 150 and the flange portion 220.

Thereby, by pressing and clamping the flange portion 220 between the support table surface 140 and the second casing 150, a position of the interface assembly 200 in the accommodation slot 112 or the casing assembly 100 may be effectively limited, and the possibility of the interface assembly 200 to be wobble or shift can be reduced, thereby improving the stability and reliability of the installation of the interface assembly 200.

At the same time, utilizing the second casing 150 to block the flange portion 220 may cause the flange portion 220 not to be exposed to the outside of the casing assembly 100, so that a user may not be able to see the flange portion 220 from the outside of the wearable device, which is conducive to enhancing the aesthetic appearance of the wearable device.

Further, the flange portion 220 may adopt different shapes to accommodate the overall structural form of the interface assembly 200 or to meet different assembly requirements.

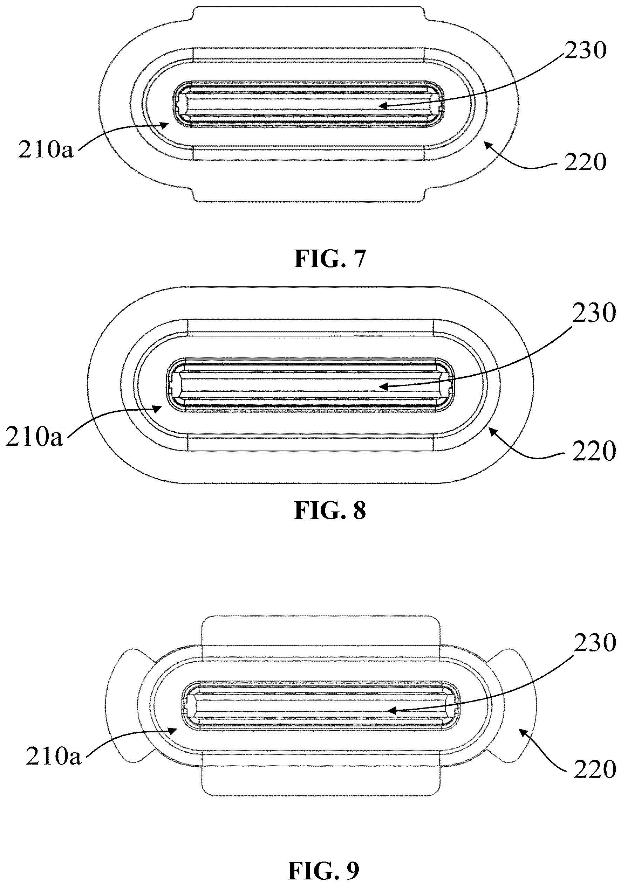

By way of example, referring to FIG. 7 and FIG. 8, the flange portion 220 is disposed in an annular structure (e.g., a regular annular or shaped annular structure), i.e., the flange portion 220 is disposed around an edge of the main body portion 210 on a side away from the accommodation cavity 111. Accordingly, the support table surface 140 may be disposed in an annular table structure around an edge of a side of the accommodation slot 112 away from the accommodation cavity 111 (i.e., a slot opening on the side of the accommodation slot 112 away from the accommodation cavity 111).

As a result, a contact area between the support table surface 140 and the flange portion 220 may be effectively increased and the support table surface 140 may provide an even and reliable support force to the interface assembly 200. In terms of the adhesive-accommodation slot, the adhesive-accommodation slot may be disposed around the slot opening on the side of the accommodation slot 112 away from the accommodation cavity 111 and set on the support table surface 140, which allows for complete adhesive application around the accommodation slot 112 during the installation of the interface assembly 200 and forms the sealant 500, thereby effectively enhancing the sealing performance.

By way of example, referring to FIG. 9, there are a plurality of flange portions 220 (e.g., two, three, or some other greater number). The plurality of flange portions 220 spaced apart around an edge of a side of the main body portion 210 away from the accommodation cavity 111. Compatibly, the support table surface 140 may be an annular table structure disposed around the edge of the side of the accommodation slot 112 away from the accommodation cavity 111, or a plurality of support structures spaced apart around the slot opening of the side of the accommodation slot 112 away from the accommodation cavity 111.

Thereby, based on the count of the flange portions 220 and an arrangement form, a multi-point fixed connection between the interface assembly 200 and the casing assembly 100 may be realized. It can be understood that generally speaking, the larger the contact area between the support surface 140 and the flange portion 220 is, the more stable the assembly of the interface assembly 200 is. Therefore, structural forms of the flange portion 220 and the support table surface 140 and a fit relationship between the flange portion 220 and the support table surface 140 may be flexibly selected according to actual needs, which will not be repeated herein.

In one embodiment, referring to FIG. 3, FIG. 4, and FIG. 6 to FIG. 13, the interface assembly 200 further includes a tongue portion 230, which is mainly used to establish an electrical connection relationship between the interface assembly 200 and the external plug. The tongue portion 230 includes a preset length in the insertion direction of the interface assembly 200, and correspondingly, the main body portion 210 is provided with a guiding cavity 210a. The guiding cavitya 210 extends from a side of the main body portion 210 proximate to the accommodation cavity 111 towards a side away from the accommodation cavity 111 and is in communication with an exterior of the interface assembly 200. While a portion of the tongue portion 230 is inserted into the guiding cavity 210a, another portion of the tongue portion 230 is disposed protruding from a side of the guiding cavity 210a away from the accommodation cavity 111 (it may also be understood that the tongue portion 230 is disposed protruding from a side of the flange portion 220 away from the accommodation cavity 111 in the insertion direction of the interface assembly 110).

By setting the tongue portion 230 protruding out of the guiding cavity 111, a length of the main body portion 210 in the insertion direction of the interface assembly 200 may be reduced, which is equivalent to reducing a length of the accommodation slot 200 and saving an assembly space of the interface assembly 200.

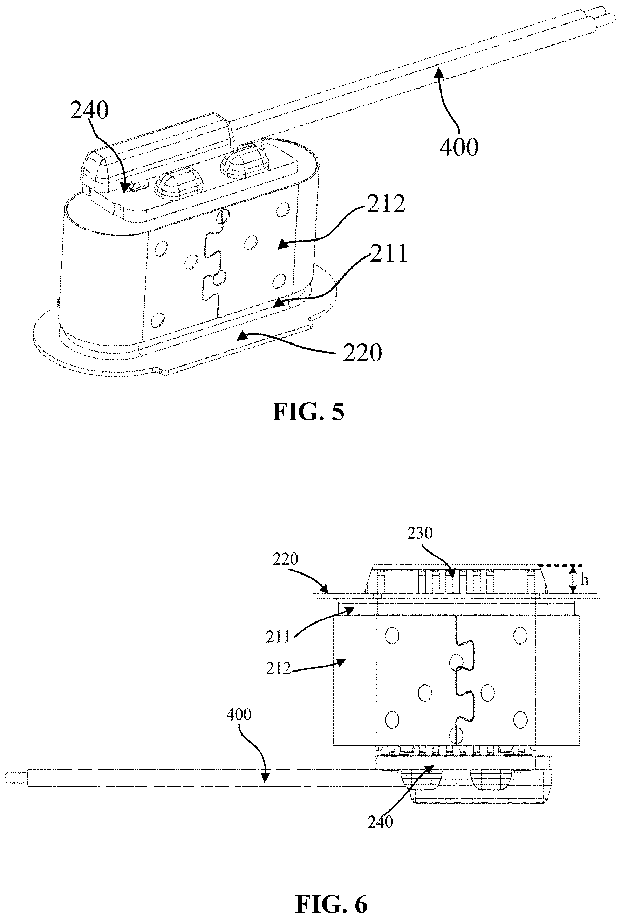

In some specific embodiments, for ease of differentiation and description, see FIG. 6, an end surface of the tongue portion 230 backing away from the main body portion 210 in the insertion direction of the interface assembly 200 is defined as a first end surface, and an end surface of the flange portion 220 backing away from the main body portion 210 in the insertion direction of the interface assembly 200 is defined as a second end surface, and a height difference between the first end surface and the second end surface may be controlled to be in a range of 0.6 mm to 1.1 mm.

Thereby, in the case where the length of the tongue portion 230 is limited and cannot be changed, by selectively setting a height difference between the tongue portion 230 and the flange portion 220, it is possible to not only ensure an insertion strength between the interface assembly 200 and the external plug, and can also create a condition for reducing the size of the accommodation slot 200 and saving the assembly space of the interface assembly 200.

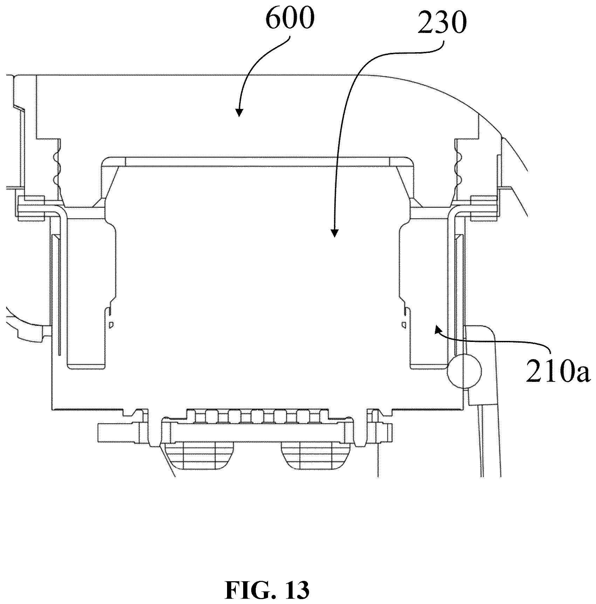

Further, referring to FIG. 13, the wearable device further includes a sealing member 600, which is mainly used to selectively block the interface assembly 200. For example, when the interface assembly 200 is not plugged into a corresponding external plug, by blocking the interface assembly 200 with the sealing member 600, impurities such as dust particles falling into the guiding cavity 210a or blocking the guiding cavity 210a may be reduced, thereby ensuring the normal usage of the interface assembly 200. When the interface assembly 200 needs to be used, the sealing member 600 can be removed to uncover the interface assembly 200.

Specifically, the sealing member 600 is arranged on the side of the main body 210 away from the accommodation cavity 111 and faces the guiding cavity 210a. A portion of the tongue portion 230 protruding from the guiding cavity 210a (hereinafter referred to as a protrusion portion of the tongue portion 230) may be utilized as a carrier for a fit connection between the interface assembly 200 and the sealing member 600, so as to position and assemble the sealing member 600 to the interface assembly 200 in a detachable or movable connection manner to block the interface assembly 200. For example, the sealing member 600 may be fitted over the protrusion portion of the tongue portion 230 and cover the guiding cavity 210a.

In one embodiment, see FIG. 5, FIG. 6, and FIG. 10, the main body portion 210 includes an inner casing 211 and an outer casing 212. The outer casing 212 is substantially a tubular body with a preset length in the insertion direction of the interface assembly 200, and a portion of the inner casing 211 is inserted within the outer casing 212 and the other portion of the inner casing 211 protrudes out of the outer casing 212. The inner casing 211 encloses the guiding cavity 210a. In some embodiments, an inner space of the inner casing 211 is the guiding cavity 210a.

More specifically, for ease of distinction and description, one end of the inner casing 211 in the insertion direction of the interface assembly 200 is defined as a first end of the inner casing 211, and the other end of the inner casing 211 in the insertion direction of the interface assembly 200 is defined as a second end of the inner casing 211. The first end of the inner casing 211 is inserted into the outer casing 212 so as to form an adhesive-accommodation slot 210b for accommodating a waterproof adhesive between an inner side of the outer casing 212 and an outer side of the first end of the inner casing 211. The second end of the inner casing 211 is set protruding out from the outer casing 212 to form the flange portion 220. In a specific implementation, the flange portion 220 is formed by flanging the second end of the inner casing 211.

It can also be understood that the adhesive-accommodation space 210b and the guiding cavity 210a are formed inside the main body portion 210 and are isolated from each other along the insertion direction of the interface assembly 200, and the adhesive-accommodation space 210b is closer to the accommodation cavity 111 than the guiding cavity 210a, i.e., the adhesive-accommodation space 210b is located on the side of the guiding cavity 210a proximate to the accommodation cavity 111.

In other embodiments, in terms of the flange portion 220, the flange portion 220 is disposed to protrude only from the second end of the inner casing 211, for example, the flange portion 220 is formed by flanging the second end of the inner casing 211, but the flange portion 220 does not protrude from the outer casing 212. At this time, the inner casing 211 may be completely inserted inside the outer casing 212, or the second end of the inner casing 211 may be exposed outside the outer casing 212, so as to form interface assembly 200 in different structural forms to satisfy different requirements.

In some embodiments, a portion of the tongue portion 230 disposed within the guiding cavity 210a may extend via the first end of the inner casing 211 into the adhesive-accommodation space 210a, which establishes an electrical connection relationship between the interface assembly 200 and the circuit board 300 based on the cooperation between the tongue portion 230 and the wire assembly 400.

Using the adhesive-accommodation space 210b as an accommodation space for the waterproof adhesive, a waterproof structure may be formed on a side of the main body portion 210 proximate to the accommodation cavity 111 by injecting the waterproof adhesive into the adhesive-accommodation space 210b, which not only effectively enhances the overall waterproof performance of the interface assembly 200, but also enhances the stability of the structural coordination between the outer casing 212 and the inner casing 211. In a process of dispensing the adhesive into the adhesive-accommodation space 210b, the waterproof adhesive may be restricted to the outer side of the first end of the inner casing 211 through a sidewall of the outer casing 212, thereby effectively preventing the waterproof adhesive from overflowing. At the same time, in some embodiments, the flange portion 220 is utilized to hold the outer casing 212, thereby limiting a relative position between the outer casing 212 and the inner casing 211 as well as a volume and size of the adhesive-accommodation space 210b, thereby enhancing the structural strength of the main body portion 210, and even the interface assembly 200 as a whole.

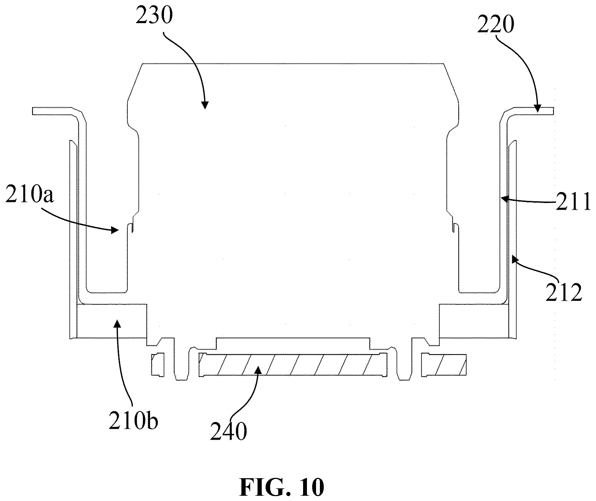

Furthermore, referring to FIG. 12 and FIG. 10, the main body portion 210 further includes a reinforcement structure 213, which may be a plate-like structure soldered and secured to the first end of the inner casing 211 and disposed within the adhesive-accommodation space 210b, or may be a raised structure disposed on an outer surface of the first end of the inner casing 211, or the like.

On the one hand, utilizing the reinforcement structure 213 not only enhances the structural strength of the inner casing 211 itself, but also enhances the connection strength between the inner casing 211 and the waterproof adhesive, and thus enhances the connection strength of the inner casing 211 and the outer casing 212, which enhances the structural stability and reliability of the main body portion 210 and the interface assembly 200.

On the other hand, the disposed reinforcement structure 213 creates a condition for downsizing the interface assembly 200 as well as decreasing the requirement for the size of the accommodation slot 112. For example, in general, in order to make the main body portion 210 have sufficient structural strength and good waterproof performance, a wall thickness of the inner casing 211 and the outer casing 212 are usually set to be in a range of 0.3 mm and 0.4 mm, and a thickness of the waterproof adhesive (i.e., a thickness of the waterproof adhesive within the adhesive-accommodation space 210b in the insertion direction of the interface assembly 200) is usually set to about 0.7 mm.

However, with the reinforcement structure 213, the wall thicknesses of the inner casing 211 and the outer casing 212 may be adjusted to be in a range of 0.1 mm and 0.3 mm (e.g., about 0.15 mm), while the thickness of the waterproof adhesive may be maintained at about 0.7 mm. Thereby, the size of the interface assembly 200 may be reduced by reducing the wall thickness of the inner casing 211 and the outer casing 212, which in turn achieves the effect of saving the assembly space, and is more conducive to realizing the miniaturized design of the wearable device.

In some embodiments, referring to FIG. 12, with respect to the tongue portion 230, an end of the tongue portion 230 that extends into the adhesive-accommodation space 210b may be fixedly connected (e.g., soldered) to the inner casing 211 with the aid of the reinforcement structure 213 to enhance the connection strength between the tongue portion 230 and the main body portion 210 and to further enhance the structural stability of the interface assembly 200.

In one embodiment, referring to FIG. 3 to FIG. 6 and FIG. 10, the interface assembly 200 further includes an external circuit board 240, which is disposed on the side of the main body portion 210 proximate to the accommodation cavity 111 (i.e., the side of the main body portion 210 backing away from the flange portion 220), and the interface assembly 200 is electrically connected to the wire assembly 400 via the external circuit board 240 and thus utilizes the wire assembly 400 to establish an electrical connection between the interface assembly 200 and the circuit board 300.

With the external circuit board 240, the circuit board 300 and circuits related to the interface assembly 200 (such as a voltage and current regulator circuit, etc.) may be transferred and disposed on the external circuit board 240, which not only reduces the size of the circuit board 300 and the requirement for the space of the accommodation cavity 111 and creates a condition for realizing the miniaturized design of the wearable device, but also realizes the integration of interface functions and facilitates the more reasonable setting of the accommodation cavity 111 and the accommodation slot 112, and enhances the flexibility of the assembly of the circuit board 300 and the interface assembly 200.

As far as the wearable device is concerned, please refer to FIG. 1 and FIG. 3, the external circuit board 240 may be transversely arranged in the accommodation slot 112 relative to the circuit board 300, i.e., a plane on which the external circuit board 240 is located is intersected (e.g., vertically intersected) with a plane on which the circuit board 300 is located at an angle. In this way, the assembly space of the circuit board 300 and the interface assembly 200 may be further saved, and the full utilization of the structural space of the casing assembly 100 can be realized.

In some embodiments, with respect to the tongue portion 230, a terminal pin of the tongue portion 230 is directly soldered to the external circuit board 240 to establish an electrical connection relationship between the tongue portion 230 and the external circuit board 240, and the external circuit board 240 is fixed on the side of the main body portion 210 proximate to the accommodation cavity 111 to build a complete structure with the interface assembly 200, so that the interface assembly 200 may be applied to the wearable device as an independent functional component.

It is to be noted that the broad structural construction of the wearable device of the embodiments of the present disclosure is shown in FIG. 1 and FIG. 3 only with the earphone as an example, but the earphone is only a specific embodiment of the wearable device, and the wearable device may also be a pair of glasses, a watch, or other devices.

The above application of specific examples to illustrate the present disclosure is only used to assist in understanding the present disclosure and is not intended to limit the present disclosure. For those skilled in the art to which the present disclosure belongs, a number of simple deductions, deformations, or substitutions may also be made based on the ideas of the present disclosure.

## Claims

1. A wearable device, comprising:
a casing assembly including a first casing, wherein the first casing is provided with an accommodation slot and an accommodation cavity, and the accommodation slot is in communication with the accommodation cavity;
an interface assembly inserted into the accommodation slot;
a circuit board disposed within the accommodation cavity; and
a wire assembly electrically connected with the circuit board and the interface assembly.

2. The wearable device of claim 1, wherein the interface assembly includes:
a main body portion inserted into the accommodation slot; and
a flange portion disposed on a side of the main body portion away from the accommodation cavity; wherein
the casing assembly is further provided with a support table surface, and the flange portion is supported by the support table surface.

3. The wearable device of claim 2, wherein the interface assembly further includes a tongue portion, the main body portion is provided with a guiding cavity, a portion of the tongue portion is inserted into the guiding cavity, and the other portion of the tongue portion protrudes out of the guiding cavity from the side of the main body portion away from the accommodation cavity.

4. The wearable device of claim 3, wherein an end surface of the tongue portion backing away from the main body portion along an insertion direction of the interface assembly is a first end surface, an end surface of the flange portion backing away from the main body portion along the insertion direction is a second end surface, and a height difference between the first end surface and the second end surface is in a range of 0.6 mm to 1.1 mm.

5. The wearable device of claim 3, further comprising a sealing member, the sealing member being arranged on the side of the main body portion away from the accommodation cavity, the sealing member being cooperatively connected with the tongue portion for selectively blocking the interface assembly.

6. The wearable device of claim 2, wherein the interface assembly further includes an external circuit board, the external circuit board being disposed on a side of the main body portion proximate to the accommodation cavity, the wire assembly being electrically connected with the external circuit board and the circuit board.

7. The wearable device of claim 6, wherein a plane on which the external circuit board is located and a plane on which the circuit board is located are intersected with each other.

8. The wearable device of claim 2, wherein the flange portion is disposed around an edge of the side of the main body portion away from the accommodation cavity; or
there are a plurality of flange portions, the plurality of flange portions being spaced apart around the edge of the side of the main body portion away from the accommodation cavity.

9. The wearable device of claim 2, wherein a sealant is disposed between the flange portion and the support table surface.

10. The wearable device of claim 9, wherein the support table surface is provided with an adhesive-accommodation slot, the flange portion covers the adhesive-accommodation slot, and at least a portion of the sealant is accommodated within the adhesive-accommodation slot; and/or
the flange portion is provided with the adhesive-accommodation slot, the support table surface covers the adhesive-accommodation slot, and at least a portion of the sealant is accommodated within the adhesive-accommodation slot.

11. The wearable device of claim 2, wherein the main body portion includes an inner casing and an outer casing, and the inner casing includes a first end and a second end opposite each other along the insertion direction of the interface assembly;
the first end of the inner casing is inserted into the outer casing, and an adhesive-accommodation space for accommodating a waterproof adhesive is formed between the outer casing and the first end of the inner casing; and
the second end of the inner casing protrudes out of the outer casing to form the flange portion.

12. The wearable device of claim 2, wherein the main body portion includes an inner casing and an outer casing, and the inner casing includes a first end and a second end opposite each other along an insertion direction of the interface assembly;
the first end of the inner casing is inserted into the outer casing, and an adhesive-accommodation space for accommodating a waterproof adhesive is formed between the outer casing and the first end of the inner casing, and the flange portion protrudes out of the second end of the inner casing.

13. The wearable device of claim 11 or 12, wherein the main body portion further includes a reinforcement structure, and the reinforcement structure is disposed at the first end of the inner casing and is located within the adhesive-accommodation space.

14. The wearable device of claim 13, wherein a wall thickness of the outer casing and/or the inner casing is in a range of 0.1 mm to 0.3 mm.

15. The wearable device of any one of claims 1 to 12, wherein the casing assembly includes a first sidewall and a second sidewall connected at an angle, a length of the first sidewall is greater than a length of the second sidewall, and the accommodation slot is disposed in the second sidewall.

16. The wearable device of any one of claims 1 to 12, wherein the wearable device is an earphone or a pair of glasses.
